# EUROPÄISCHE PATENTSCHRIFT

(11) **EP 1 891 454 B1**
(45) Veröffentlichungstag und Bekanntmachung des Hinweises auf die Patenterteilung: **06.01.2010**
(21) Anmeldenummer: 06763620.9
(22) Anmeldetag: 09.06.2006
(51) Int. Cl.: G01R 31/30

(54) **VERLUSTFREIE HOCHSTROMPRÜFANLAGE**
LOSS-FREE HIGH CURRENT TEST STATION
INSTALLATION DE VERIFICATION DE COURANT ELEVE SANS PERTE

(30) Priorität: 14.06.2005 DE 102005028270
(43) Veröffentlichungstag der Anmeldung: 27.02.2008
(73) Patentinhaber: SIEMENS AKTIENGESELLSCHAFT, 80333 München (DE)
(72) Erfinder: FLOTTEMESCH, Jörg, 91088 Bubenreuth (DE); MOSER, Jürgen, 91301 Forchheim (DE)
(86) Internationale Anmeldenummer: PCT/EP2006/063053
(87) Internationale Veröffentlichungsnummer: WO 2006/134076

(56) Entgegenhaltungen:
- CUZNER R M ET AL: "Control and implementation issues with paralleling soft-switched drive systems" CONFERENCE RECORD OF THE 2003 IEEE INDUSTRY APPLICATIONS CONFERENCE. 38TH. IAS ANNUAL MEETING . SALT LAKE CITY, UT, OCT. 12 - 16, 2003, CONFERENCE RECORD OF THE IEEE INDUSTRY APPLICATIONS CONFERENCE. IAS ANNUAL MEETING, NEW YORK, NY : IEEE, US, Bd. VOL. 3 OF 3. CONF. 38, 12. Oktober 2003 (2003-10-12), Seiten 2018-2025, XP010676181 ISBN: 0-7803-7883-0
- SIYOUNG KIM ET AL: "AC to AC power conversion based on matrix converter topology with unidirectional switches" APPLIED POWER ELECTRONICS CONFERENCE AND EXPOSITION, 1998. APEC '98. CONFERENCE PROCEEDINGS 1998., THIRTEENTH ANNUAL ANAHEIM, CA, USA 15-19 FEB. 1998, NEW YORK, NY, USA,IEEE, US, Bd. 1, 15. Februar 1998 (1998-02-15), Seiten 301-307, XP010263610 ISBN: 0-7803-4340-9
- PICCI G ET AL: "Endurance test circuit for power capacitors" POWER MODULATOR SYMPOSIUM, 1998. CONFERENCE RECORD OF THE 1998 TWENTY-THIRD INTERNATIONAL RANCHO MIRAGE, CA, USA 22-25 JUNE 1998, NEW YORK, NY, USA,IEEE, US, 22. Juni 1998 (1998-06-22), Seiten 251-254, XP010318989 ISBN: 0-7803-4244-5

## Beschreibung

Die vorliegende Erfindung betrifft eine Hochstromprüfanlage zum Überprüfen des Verhaltens eines Prüflings bei Wechselstrombelastung.

Hochstromprüfanlagen sind aus dem Stand der Technik bereits bekannt. So weisen vorbekannte Hochstromprüfanlagen in der Regel einen Anschlusstransformator auf, dessen Primärwicklung mit einem Energie einspeisenden Energieversorgungsnetz verbindbar ist. Sekundärseitig ist der Anschlusstransformator mit einem Prüfling verbunden. Zur Stromerzeugung wird der Prüfling über eine Impedanz kurzgeschlossen, wobei die Impedanz die Höhe des Stromflusses durch den Prüfling bestimmt. Den vorbekannten Hochstromanlagen haftet jedoch der Nachteil an, dass zum Einstellen unterschiedlicher Versorgungsspannungen kostenintensive und in ihren Einstellmöglichkeiten begrenzte Spannungstransformatoren eingesetzt werden müssen. Darüber hinaus geht bei der Prüfung die gesamte aufgewendete Energie als Verlustwärme verloren, so dass bei jeder Prüfung hohe Prüfkosten verursacht werden.

Im Stand der Technik sind vielfältige Wechselstromkonvertierungssysteme, insbesondere im Bereich der Motorsteuerung, bekannt. Im Artikel "Control and Implementation Issues with Paralleling Soft-Switches Drive System" von Cuzner et al., Conference Record of 2003, IEEE Conference, Seiten 2018 bis 2025 ist ein mathematisches Modell einer Motorsteuerung zur aktiven Kompensation von zirkulierenden Gleichtaktstörspannungen beschrieben. In dem Artikel "AC to AC Power Conversion Based on Matrix Converter Topology With Unidirectional Switches" von Siyoung et al., APEC '98 Conference Proeeding, Bd. 1, Seiten 301 bis 307 ist eine AC-AC-Spannungskonversion mittels Leistungshalbleiterventilen, und antiparallel geschalteten Dioden zum insbesonderen Einsatz einer Motorsteuerung offenbart.

Aufgabe der Erfindung ist es daher, eine Hochstromprüfanlage bereit zu stellen, mit der eine flexible und kostengünstige Überprüfung des Verhaltens eines Prüflings bei hohen Strömen ermöglicht ist.

Die Erfindung löst diese Aufgabe durch eine Hochstromprüfanlage mit einem Anschlusstransformator zum primärseitigen Anschluss einer Drehspannungsversorgung und einem mit dem Anschlusstransformator sekundärseitig verbundenen und mehrere Prüfphasen aufweisenden Prüfkreis, wobei der Prüfkreis einen Prüfanschluss zum seriellen Anschluss des Prüflings und eine parallel zum Prüfungsanschluss geschaltete Hochstromkurzkupplung aufweist.

Erfindungsgemäß wird auf das Herbeiführen eines Kurzschlussstromes verzichtet. Stattdessen kommt eine Hochstromkurzkupplung zum Einsatz, die als Strompumpe wirkt. Der Aufbau einer Hochstromkurzkupplung ist als solche bekannt, so dass hier nur grob darauf eingegangen zu werden braucht. So weist die Hochstromkurzkupplung im Rahmen der Erfindung einen Gleichrichter auf, der über einen Gleichstromkreis mit einem Wechselrichter verbunden ist. Gleichrichter und Wechselrichter bestehen jeweils aus einer als solchen bekannten Brückenschaltung mit selbst gesteuerten Leistungshalbleiterventilen. Selbstgesteuerte Leistungshalbleiterventile könnten im Megahertzbereich getaktet und dabei zwischen einer Durchgangsstellung, in der ein Stromfluss über das Leistungshalbleiterventil ermöglicht ist, und einer Sperrstellung, in der ein Stromfluss über das Leistungshalbleiterventil unterbrochen ist, hin- und hergeschaltet werden. Durch die hohe Taktrate sind Wechselströme erzeugbar, deren Höhe, Frequenz und Phasenlage auf einfache Weise durch eine entsprechende Steuerung - in der Regel eine Pulsweitenmodulation - bestimmt werden können. Durch die von der Hochstromkurzkupplung erzeugten Ströme und die Anordnung der Hochstromkurzkupplung und des Prüfanschlusses in einem gemeinsamen Prüfkreis kann der Prüfling, abgesehen von den internen Stromrichterverlusten, nahezu verlustfrei geprüft werden.

Vorteilhafterweise ist der Eingangstransformator über eine Niederstromkurzkupplung mit dem Prüfkreis verbunden. Die Niederstromkurzkupplung weist nahezu den gleichen Aufbau wie die Hochstromkurzkupplung auf und ermöglicht eine beliebige Spannungs- und Frequenzversorgung des Prüfkreises. Ein wesentlicher Vorteil der Niederstromkurzkupplung besteht in dem Ausgleich der Verluste der Hochstromkurzkupplung, die beim Umrichten zwangsläufig entstehen.

Bei einer bevorzugten Weiterentwicklung der Erfindung erfolgt der Anschluss der Hochstromkurzkupplung durch Verkreuzen der Prüfphasen am Prüfungsanschluss phasenverschoben. Diese Phasenverschiebung eignet sich insbesondere zum Prüfen eines Schalters, bei dem neben der Ausschaltfunktion auch seine Einschaltfestigkeit zu überprüfen ist. Beim Anschluss eines Schalters an den Prüfungsanschluss käme es beim Einschalten des Schalters ohne die Verkreuzung der Prüfphasen zu keinem Spannungsabfall und somit zum Ausbleiben eines Stromflusses beim Einschalten. Die Phasenverschiebung ermöglicht daher einen Stromfluss bereits beim Einschalten des Schalters. Nach dem Einschalten des Schalters regelt die interne Regelung der Hochspannungskurzkupplung die Phasenlage des von ihr ausgegebenen Drehspannungsnetzes so, dass ein zuvor eingestellter Prüfstrom im Prüfkreis fließt. Werden die Kontakte des zu prüfenden Schalters getrennt, regelt die Hochstromkurzkupplung wieder auf die ursprüngliche Phasenlage zurück, so dass an den Klemmen des Schalters wieder die volle Prüfspannung entsteht.

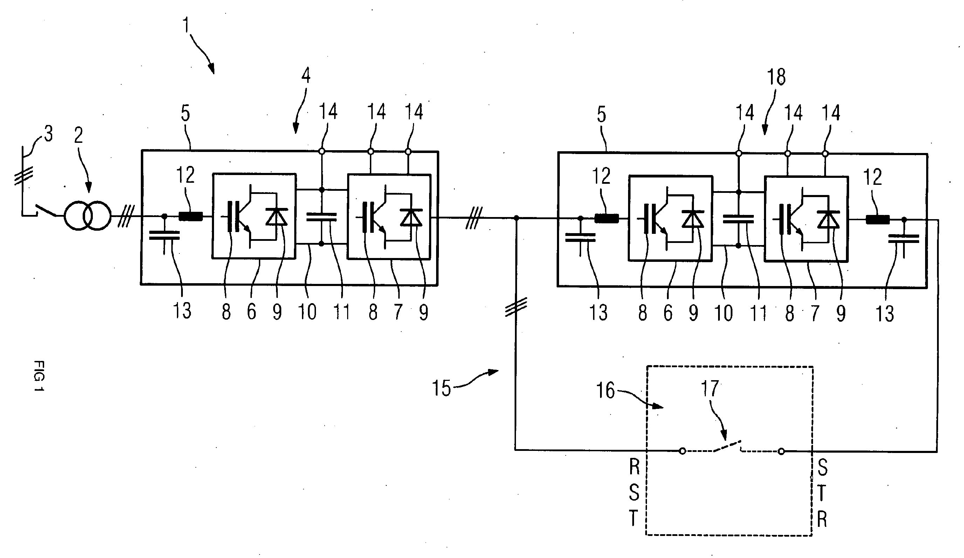

Weitere zweckmäßige Ausgestaltungen und Vorteile sind Gegenstand der nachfolgenden Beschreibung von Ausführungsbeispielen der Erfindung unter Bezug auf die Figuren der Zeichnung, wobei die
- Figur: ein Ausführungsbeispiel der erfindungsgemäßen Hochstromprüfanlage verdeutlicht.

Die Figur verdeutlicht ein Ausführungsbeispiel der erfindungsgemäßen Hochstromprüfanlage 1, die über einen Anschlusstransformator 2 an ein Energieversorgungsnetz 3 anschließbar ist. Wie durch die drei Querstriche angedeutet, handelt es sich bei dem Energieversorgungsnetz 3 um ein dreiphasiges Wechselspannungsnetz. Der Anschlusstransformator 2 ist sekundärseitig mit einer Niederstromkurzkupplung 4 verbunden, die ein Gehäuse 5 aufweist, in dem ein Gleichrichter 6 sowie ein Wechselrichter 7 angeordnet sind, deren Aufbau nur schematisch angedeutet ist. Wie dem Fachmann bekannt ist, bestehen der Gleichrichter 6 und der Umrichter 7, insbesondere im Bereich der Mittelspannung bei Spannungen im Bereich von 1 kV bis 50 kV, üblicherweise aus einer 6-Puls-Brückenschaltung mit selbstgesteuerten Leistungshalbleiterventilen 8, wie IGBTs, GTOs oder IGCTs, von denen in der Figur sowohl für den Gleichrichter 6 als auch für den Wechselrichter 7 jeweils nur eines dargestellt ist. Dabei ist jedem Leistungshalbleiterventil 8 eine Freilaufdiode 9 parallel geschaltet. Der Gleichspannungskreis 10 weist als Energiespeicher einen Kondensator 11 auf.

Die Niederstromkurzkupplung 4 verfügt ferner über eine Drosselspule 12 sowie einen weiteren Kondensator 13 zum Unterdrücken von Oberschwingungen, die beim Umrichten entstehen. Wie bereits ausgeführt wurde, ist der Aufbau einer solchen Kurzkupplung dem Fachmann bestens bekannt, so dass an dieser Stelle nicht detailliert darauf eingegangen wird. Im Wesentlichen erzeugt der Gleichrichter 6 im Gleichstromkreis 10 eine Gleichspannung, deren Amplitude von der Ansteuerung oder Taktung der Leistungshalbleiterventile 8 abhängig ist. Diese Gleichspannung wird durch den Wechselrichter 9 wieder in eine Wechselspannung umgewandelt, wobei die Amplitude, Frequenz und die Phasenlage des von der Wechselspannung getriebenen Wechselströmes durch zweckmäßige Steuerung beliebig eingestellt werden können. Zum Ansteuern der Niederstromkurzkupplung 4 weist diese zweckmäßige Anschlüsse 14 auf.

An ihrer vom Anschlusstransformator 2 abgewandten Seite ist die Niederstromkurzkupplung 4 mit einem Prüfkreis 15 verbunden, der ebenfalls aus drei Prüfphasen besteht. Seriell in den Prüfkreis 15 geschaltet ist ein Prüfanschluss 16, an dem in dem gezeigten Ausführungsbeispiel ein dreipoliger Leistungsschalter 17 angeschlossen ist. Parallel zum Prüfanschluss 16 weist der Prüfkreis 15 eine Hochstromkurzkupplung 18 auf, die der Niederstromkurzkupplung 4 entsprechend aufgebaut ist, jedoch zum Pumpen hoher Ströme ausgelegt ist. Mit anderen Worten unterscheidet sich die Hochstromkurzkupplung 18 zwar durch die verwendeten und für höhere Ströme ausgelegten Komponenten, nicht jedoch durch die grundsätzliche Verschaltung von der Niederstromkurzkupplung.

Die Hochstromkurzkupplung 18 ist um 120 Grad phasenverschoben an den Prüfanschluss 16 angeschlossen. Durch Schließen des Schalters 17 ist die mit "R" gekennzeichnete Phase mit einer S-Phase verbunden, die in der Figur links vom Prüfanschluss 16 dargestellte "S"-Phase mit einer "T"-Phase und die links vom Prüfanschluss 16 dargestellte "T"-Phase mit einer "R"-Phase. Durch dieses Verkreuzen fällt bereits über den geöffneten Schalter eine Spannung ab, so dass dieser beispielsweise beim Schließen auf seine Einschaltfestigkeit überprüft werden kann. Nach dem Schließen des Schalters regelt die Hochstromkurzkupplung die Phasenlage je nach Wunsch und Zweckmäßigkeit der Prüfung. Beim Ausschalten des Schalters führt die Hochstromkurzkupplung die Phasenlage jedoch wieder auf 0 Grad zurück, so dass die ursprüngliche Prüfspannung wieder an den Klemmen des Schalters anliegt.

## Patentansprüche

1. Hochstromprüfanlage (1) mit einem Anschlusstransformator (2) zum primärseitigen Anschluss einer Drehspannungsversorgung (3) und einem mit dem Anschlusstransformator (2) sekundärseitig verbundenen und mehrere Prüfphasen aufweisenden Prüfkreis (15), wobei der Prüfkreis (15) einen Prüfanschluss (16) zum seriellen Anschluss eines Prüflings (17) und eine parallel zum Prüfanschluss (16) geschaltete Hochstromkurzkupplung (18), umfassend einen Gleichrichter und einen Wechselrichter bestehend aus jeweils einer als Brückenschaltung mit selbstgesteuerten Leistungshalbleiterventilen, aufweist.

2. Hochstromprüfanlage (1) nach Anspruch 1,
**dadurch gekennzeichnet, dass**
der Anschlusstransformator (2) über eine Niederstromkurzkupplung (4), umfassend einen Gleichrichter und einen Wechselrichter bestehend aus einer Brückenschaltung mit selbstgesteuerten Leistungshalbleiterventilen, mit dem Prüfkreis (15) verbunden ist.

3. Hochstromprüfanlage (1) nach Anspruch 1 oder 2,
**dadurch gekennzeichnet, dass**
der Anschluss der Hochstromkurzkupplung (18) an den Prüfungskreis (15) durch Verkreuzen der Prüfphasen am Prüfanschluss (16) phasenverschoben erfolgt.

4. Hochstromprüfanlage (1) nach einem der Ansprüche 1 bis 3,
**dadurch gekennzeichnet, dass**
die selbstgesteuerten Leistungshalbleiterventile im Megahertzbereich taktbar sind.

## Claims

1. High-current test installation (1) having a connecting transformer (2) for primary-side connection of a polyphase voltage supply (3) and a test circuit (15), which is connected on the secondary side to the connecting transformer (2) and has a plurality of test phases, with the test circuit (15) having a test connection (16) for series connection of a unit under test (17), and having a high-current back-to-back link (18) which is connected in parallel with the test connection (16), comprising a rectifier and an inverter, each comprising a bridge circuit with self-controlled power semiconductor valves.

2. High-current test installation (1) according to Claim 1, **characterized in that** the connecting transformer (2) is connected to the test circuit (15) via a low-current back-to-back link (4) comprising a rectifier and an inverter, comprising a bridge circuit with self-controlled power semiconductor valves.

3. High-current test installation (1) according to Claim 1 or 2, **characterized in that** the high-current back-to-back link (18) is connected to the test circuit (15) with a phase shift by crossing over the test phases at the test connection (16).

4. High-current test installation (1) according to one of Claims 1 to 3, **characterized in that** the self-controlled power semiconductor valves can be clocked in the Megahertz range.

## Revendications

1. Installation ( 1 ) de contrôle de courant très intense, comprenant un transformateur ( 2 ) de raccordement pour le raccordement du côté primaire d'une alimentation ( 3 ) en tension polyphasée et un circuit ( 15 ) de contrôle relié du côté secondaire au transformateur ( 2 ) de raccordement et ayant plusieurs phases de contrôle, le circuit ( 15 ) de contrôle ayant une connexion ( 16 ) de contrôle pour le raccordement en série d'une éprouvette ( 17 ) et un couplage ( 18 ) instantané de courant très intense monté en parallèle à la connexion ( 16 ) de contrôle et comprenant un redresseur et un onduleur constitués respectivement d'un circuit en pont ayant des valves de puissance à semi-conducteur automatiques.

2. Installation ( 1 ) de contrôle de courant très intense suivant la revendication 1,
**caractérisée en ce que**
le transformateur ( 2 ) de raccordement est relié au circuit ( 15 ) de contrôle par un couplage ( 4 ) instantané à courant de basse intensité, comprenant un redresseur et un onduleur constitué d'un circuit en pont ayant des valves de puissance à semi-conducteur automatiques.

3. Installation ( 1 ) de contrôle de courant très intense suivant la revendication 1 ou 2,
**caractérisée en ce que**
la connexion du couplage ( 18 ) instantanée à courant très intense au circuit ( 15 ) de contrôle s'effectue de manière décalée en phase en croisant les phases de contrôle à la connexion ( 16 ) de contrôle.

4. Installation ( 1 ) de contrôle de courant très intense suivant l'une des revendications 1 à 3,
**caractérisée en ce que**
les valves à semi-conducteur de puissance automatiques peuvent être cadencées dans le domaine du mégahertz.
